# EUROPEAN PATENT APPLICATION

(11) **EP 4 761 516 A1**
(43) Date of publication of application: **17.06.2026**
(21) Application number: 25212053.0
(22) Date of filing: 29.10.2025
(51) Int. Cl.: H10F 10/165, H10F 77/20, H10F 77/30

(54) **SOLAR CELL, TANDEM SOLAR CELL AND PHOTOVOLTAIC MODULE**

(30) Priority: 10.12.2024 CN 202411815429
(71) Applicant: JINKO SOLAR CO., LTD., Shangrao, Jiangxi 334100 (CN); Zhejiang Jinko Solar Co., Ltd., Haining, Zhejiang 314416 (CN)
(72) Inventor: ZHANG, Bike, Shangrao, Jiangxi (CN); ZHANG, Xinyu, Shangrao, Jiangxi (CN); WANG, Dong, Shangrao, Jiangxi (CN); JIN, Jingsheng, Shangrao, Jiangxi (CN)
(74) Representative: Algemeen Octrooi- en Merkenbureau B.V.

(57) **Abstract**

Provided are a solar cell, a tandem solar cell and a photovoltaic module. The solar cell includes a substrate, a tunneling layer, a doped conductive layer, a first passivation layer, a first anti-reflection layer and first finger electrodes. A first surface of the substrate includes a first region and a second region. The first region includes first sub-regions. The tunneling layer is formed over the first region. The doped conductive layer is formed over a side of the tunneling layer away from the substrate. The first passivation layer is formed over a side of the doped conductive layer away from the tunneling layer and over the second region. The first anti-reflection layer is formed over a side of the first passivation layer away from the substrate. The first finger electrode is disposed at the first sub-region. At least one of the first finger electrodes is electrically connected to the doped conductive layer. A distance L1 between the first finger electrode and an edge of the first sub-region corresponding to the first finger electrode in the first direction is in a range of 50µm≤L1≤800µm. Such a design can reduce the optical parasitic absorption of the doped conductive layer while ensuring the performance of lateral transport of carriers, thereby improving the photoelectric conversion efficiency of the solar cell.

## Description

### TECHNICAL FIELD

The present disclosure relates to the technical field of solar cells, and in particular, to a solar cell, a tandem solar cell and a photovoltaic module.

### BACKGROUND

A solar cell can convert solar energy into electric energy. Typically, a back surface of the solar cell can form a tunneling passivation contact structure by using a tunneling layer and a doped conductive layer. Currently, the doped conductive layer has relatively severe optical parasitic absorption problems, which adversely affects the short-circuit current of the solar cell.

### SUMMARY

In view of this, embodiments of the present disclosure provides a solar cell, a tandem solar cell, and a photovoltaic module, so as to solve the above technical problems in the related art and to improve the performance of lateral transport of carriers.

In a first aspect, one or more embodiments of the present disclosure provide a solar cell. The solar cell includes a substrate, a tunneling layer, a doped conductive layer, a first passivation layer, a first anti-reflection layer and first finger electrodes. The substrate has a first surface along a thickness direction of the substrate. The first surface includes a first region and a second region. The first region includes first sub-regions. The first sub-regions and the second region are alternately arranged along a first direction. The first direction is orthogonal to the thickness direction of the substrate. The tunneling layer is formed over the first region. The doped conductive layer is formed over a side of the tunneling layer away from the substrate. The first passivation layer is formed over a side of the doped conductive layer away from the tunneling layer and over the second region. The first anti-reflection layer is formed over a side of the first passivation layer away from the substrate. The first finger electrodes are distributed along the first direction and disposed at the first sub-regions in one-to-one correspondence. At least one of the first finger electrodes is electrically connected to the doped conductive layer. A distance L1 between the first finger electrode and an edge of the first sub-region corresponding to the first finger electrode in the first direction is in a range of 50µm≤L1≤800µm.

In one or more embodiments, along the first direction, the first finger electrode located at a central region of the substrate is designated as a central finger electrode. The first finger electrode located at an edge region of the substrate is designated as an edge finger electrode. A distance between the center finger electrode and an edge of the first sub-region corresponding to the center finger electrode in the first direction is L11. A distance between the edge finger electrode and an edge of the first sub-region corresponding to the edge finger electrode in the first direction is L12. L11 is greater than L12, or L11 is smaller than L12.

In one or more embodiments, a distance L11 between the central finger electrode and the edge of the first sub-region corresponding to the central finger electrode in the first direction is in a range of 100µm≤L11≤400µm. A distance L12 between the edge finger electrode and the edge of the first sub-region corresponding to the edge finger electrode in the first direction is in a range of 50µm≤L12≤800µm.

In one or more embodiments, the solar cell further includes first busbars. The first busbars are arranged along a second direction orthogonal to the first direction. Along the thickness direction of the substrate, the first busbar is located on a side of the first finger electrode away from the substrate and is electrically connected to the first finger electrode. The first region further includes second sub-regions. The second sub-region is connected between any two adjacent first sub-regions. The second sub-regions and the second region are alternately arranged along the second direction and the second sub-regions are arranged corresponding to the first busbars. Along the thickness direction of the substrate, a projection of a partial structure of the first busbar is located in the first sub-region, and a projection of another partial structure of the first busbar is located in the second sub-region.

In one or more embodiments, a distance L2 between the first busbar and an edge of the second sub-region corresponding to the first busbar in the second direction is in a range of 0µm≤L2≤400µm.

In one or more embodiments, the first busbar located at a central region of the substrate is designated as a central busbar. The first busbar located at an edge region of the substrate is designated as an edge busbar. A distance between the central busbar and the edge of the second sub-region corresponding to the central busbar in the second direction is L21. A distance between the edge busbar and the edge of the second sub-region corresponding to the edge busbar in the second direction is L22. L21 is greater than L22, or L21 is smaller than L22.

In one or more embodiments, along the thickness direction of the substrate, a thickness D1 of the doped conductive layer is in a range of 60nm≤D1≤300nm.

In one or more embodiments, along the thickness direction of the substrate, a distance from the first region to the second region is H. H is in a range of 0.5µm≤H≤10µm.

In one or more embodiments, the solar cell further includes an emitter, a second passivation layer, and a second anti-reflection layer. The substrate has a second surface opposite to the first surface along the thickness direction of the substrate. The emitter is formed in the second surface or on the second surface. Along the thickness direction of the substrate, the second passivation layer is formed over a side of the emitter away from the substrate, and the second anti-reflection layer is formed over a side of the second passivation layer away from the substrate.

In a second aspect, one or more embodiments of the present disclosure provide a photovoltaic module, including at least one cover plate, at least one encapsulation layer, and at least one solar cell string. The solar cell string includes a plurality of solar cells as described in any one of the above embodiments. The encapsulation layer is located between the cover plate and the solar cell string, the cover plate is connected to the solar cell string through the encapsulation layer.

In a third aspect, one or more embodiments of the present disclosure provide a tandem solar cell, including a crystalline silicon bottom cell and a perovskite top cell. The crystalline silicon bottom cell includes the back-contact solar cell described above, and the perovskite top cell is electrically connected to the crystalline silicon bottom cell.

In one or more embodiments of the present disclosure, the tunneling layer and the doped conductive layer are only disposed at the first region, enabling the first finger electrode to form a good ohmic contact with the doped conductive layer. The tunneling layer and the doped conductive layer are not disposed at the second region, thereby reducing the optical parasitic absorption, increasing the short-circuit current of the solar cell, and thus improving the photoelectric conversion efficiency of the solar cell. Additionally, the first passivation layer and the first anti-reflection layer are disposed at the second region, and the first passivation layer and the first anti-reflection layer can provide a good passivation effect for the second region. Therefore, the passivation performance and the contact performance of the first surface of the substrate of the solar cell can be guaranteed, while reducing the optical parasitic absorption of the doped conductive layer. The distance L1 is designed to be 50µm to 800µm, thereby ensuring the lateral transport rate of carriers while reducing the optical parasitic absorption of the doped conductive layer, further improving the photoelectric conversion efficiency of the solar cell while facilitating the preparation of the first finger electrode.

It should be understood that the general description above and the detailed description in the following are merely illustrative, and cannot limit the present disclosure.

### BRIEF DESCRIPTION OF DRAWINGS

In order to better illustrate the technical solutions in embodiments of the present disclosure, the drawings used in the description of embodiments are briefly described as below. It will be apparent that the drawings described below are merely some embodiments of the present disclosure, rather than all of them.
FIG. 1 is a partial schematic diagram of a solar cell according to one or more embodiments of the present disclosure;
FIG. 2 is a partial schematic diagram of a first surface of a substrate of a solar cell according to one or more embodiments of the present disclosure;
FIG. 3 is a partial schematic diagram of a first surface of a substrate of a solar cell according to one or more embodiments of the present disclosure;
FIG. 4 is a partial schematic diagram of a first finger electrode and a first sub-region corresponding thereto according to one or more embodiments of the present disclosure;
FIG. 5 is a partial schematic diagram of a central finger electrode and a first sub-region corresponding thereto according to one or more embodiments of the present disclosure;
FIG. 6 is a partial schematic diagram of an edge finger electrode and a first sub-region corresponding thereto according to one or more embodiments of the present disclosure;
FIG. 7 is a partial schematic diagram of a first surface of a substrate of a solar cell according to one or more embodiments of the present disclosure;
FIG. 8 is a partial schematic diagram of a first surface of a substrate of a solar cell according to one or more embodiments of the present disclosure;
FIG. 9 is a partial schematic diagram of a first surface of a substrate of a solar cell according to one or more embodiments of the present disclosure;
FIG. 10 is a partial schematic diagram of a first busbar and a second sub-region corresponding thereto according to one or more embodiments of the present disclosure;
FIG. 11 is a partial schematic diagram of a central busbar and a second sub-region corresponding thereto according to one or more embodiments of the present disclosure;
FIG. 12 is a partial schematic diagram of an edge busbar and a second sub-region corresponding thereto according to one or more embodiments of the present disclosure;
FIG. 13 is a partial schematic diagram of a solar cell according to one or more embodiments of the present disclosure; and
FIG. 14 is a schematic diagram of a photovoltaic module according to one or more embodiments of the present disclosure.

Reference signs:
1- solar cell; 11 - substrate; 111 - first surface; 1111 - first region; 1111a - first sub-region; 1111b - second sub-region; 1112 - second region; 112 - second surface; 12 - tunneling layer; 13 - doped conductive layer; 14 - first passivation layer; 15 - first anti-reflection layer; 16 - first finger electrode; 161 - central finger electrode; 162 - edge finger electrode; 17 - first busbar; 171 - central busbar; 172 - edge busbar; 18 - emitter; 191 - second passivation layer; 192 - second anti-reflection layer; 193 - second finger electrode; 100 - photovoltaic module; 10 - solar cell string; 20 - first cover plate; 30 - first encapsulation layer; 40 - second encapsulation layer; 50 - second cover plate.

### DESCRIPTION OF EMBODIMENTS

In order to better understand the technical solutions of the present disclosure, embodiments of the present disclosure are described in detail below in conjunction with the drawings.

It is to be made clear that the described embodiments are only some rather than all of embodiments of the present disclosure.

The terms used in embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

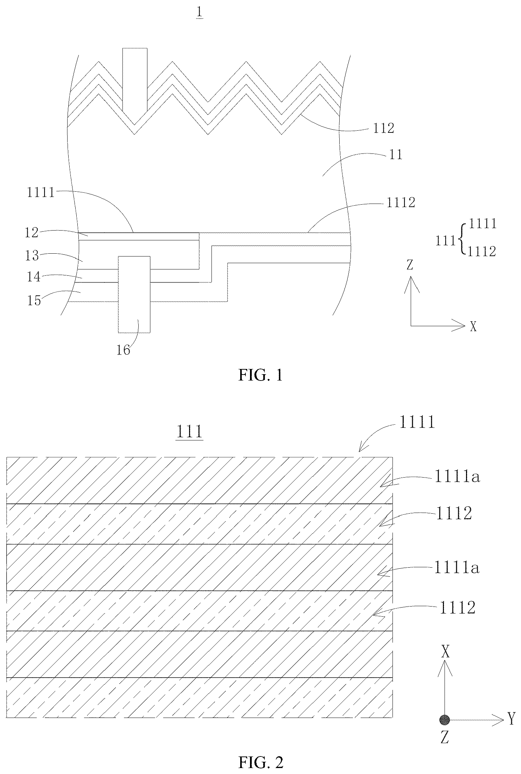

As shown in FIG. 1, one or more embodiments of the present disclosure provide a solar cell 1, including a substrate 11. The substrate 11 may be an N-type substrate or a P-type substrate. The N-type substrate may be a silicon substrate doped with an N-type element. The N-type element may specifically be one or a combination of pentavalent (group V) elements such as phosphorus, arsenic or antimony. The P-type substrate may be a silicon substrate doped with a P-type element. The P-type element may be specifically one or a combination of trivalent elements (group III) such as boron, indium, or gallium. A structure of the solar cell 1 will be described below by taking an N-type substrate as an example.

The substrate 11 has a first surface 111 and a second surface 112 disposed opposite to each other along a thickness direction Z of the substrate. The first surface 111 may be a back surface of the substrate 11, that is, a surface that is not directly irradiated by the sunlight. The second surface 112 may be a front surface of the substrate 11, that is, a surface that can be directly irradiated by the sunlight. Both the first surface 111 and the second surface 112 may receive sunlight and convert light energy into electrical energy.

In conjunction with FIG. 2, the first surface 111 includes a first region 1111 and a second region 1112. The first region 1111 include a first sub-region 1111a. The first sub-region 1111a and the second region 1112 are alternately arranged along a first direction X. The first direction X is orthogonal to the thickness direction Z of the substrate 11.

The tunneling layer 12 is disposed at the first region 1111. The tunneling layer 12 may include at least one of silicon oxide, aluminium oxide, silicon nitride, silicon oxynitride, amorphous silicon, and polycrystalline silicon. The lattice of the tunneling layer 12 can be well matched with the lattice of the substrate 11, such that the tunneling layer 12 can well passivate the first surface 111 of the substrate 11 to reduce the recombination rate of photogenerated electrons and photogenerated holes in the substrate 11 at the first surface 111 of the substrate 11.

In some embodiments, along the thickness direction Z of the substrate 11, the thickness of the tunneling layer 12 may be in a range of 0.5nm to 2nm, for example, 0.5nm, 0.8nm, 1nm, 1.2nm, 1.4nm, 1.6nm, 1.8nm, or 2nm, or other values within the above range. By limiting the thickness of the tunneling layer 12, the tunneling layer 12 can have good passivation performance and facilitate the transport of carriers.

Along the thickness direction Z of the substrate 11, a doped conductive layer 13 is disposed on a side of the tunneling layer 12 away from the substrate 11. The tunneling layer 12 and the doped conductive layer 13 may form a tunneling passivation contact structure, thereby bending an energy band of the first surface 111 of the substrate 11 to form a field passivation effect, thus realizing selective transmission of the carriers and reducing the recombination loss. The doping elements in the doped conductive layer 13 are the same as those in the substrate 11. For example, when the substrate 11 is the N-type substrate 11, the doped conductive layer 13 may be an N-type doped conductive layer, which may include at least one of N-type doped amorphous silicon, N-type doped polycrystalline silicon, N-type doped microcrystalline silicon, and N-type doped silicon carbide. The tunneling passivation contact structure formed by the tunneling layer 12 and the doped conductive layer 13 can improve the efficiency of collecting electrons by the doped conductive layer 13, which significantly increases the probability of electron tunneling, thereby facilitating improving the open-circuit voltage and short-circuit current of the solar cell 1, and thus further improving the photoelectric conversion efficiency of the solar cell 1.

Along the thickness direction Z of the substrate 11, a projection of the tunneling layer 12 overlaps with the first region 1111, and a projection of the doped conductive layer 13 also overlaps with the first region 1111.

The first passivation layer 14 is disposed on a side of the doped conductive layer 13 away from the tunneling layer 12 and disposed at the second region 1112. The first passivation layer 14 may be an aluminium oxide layer. The first passivation layer 14 may enhance the carrier concentration at the surface of the solar cell 1 and improve the short-circuit current and open-circuit voltage of the solar cell 1, thereby improving the photoelectric conversion efficiency of the solar cell 1. In some embodiments, along the thickness direction Z of the substrate 11, the thickness of the first passivation layer 14 is in a range of 2nm to 10nm, for example, 2nm, 3nm, 4nm, 5nm, 6nm, 7nm, 8nm, 9nm or 10nm, or other values within the above range. By limiting the thickness of the first passivation layer 14, the first passivation layer 14 can achieve a good passivation effect.

The first anti-reflection layer 15 is disposed on a side of the first passivation layer 14 away from the substrate 11. The first anti-reflection layer 15 may be one or a combination of silicon oxide, silicon nitride, and silicon oxynitride. Taking silicon nitride as an example, the silicon nitride can provide field passivation to reduce the recombination of carriers. The silicon nitride also has an anti-reflection function to reduce the reflection of sunlight, and is disposed on the first surface 111 of the substrate 11 to improve the light transmittance of the back surface of the solar cell 1, thereby enhancing the carrier concentration on the surface of the substrate 11, improving the short-circuit current and open-circuit voltage of the solar cell 1, and thus improving the photoelectric conversion efficiency of the solar cell 1.

In some embodiments, along the thickness direction Z of the substrate 11, the thickness of the first anti-reflection layer 15 is in a range of 30nm to 150nm, for example, 30nm, 40nm, 50nm, 60nm, 70nm, 80nm, 90nm, 100nm, 110nm, 120nm, 130nm, 140nm, or 150nm, or other values within the above range. By limiting the thickness of the first anti-reflection layer 15, the passivation effect and the anti-reflection effect of the first anti-reflection layer 15 can be ensured, thus is beneficial to improving the photoelectric conversion efficiency of the solar cell 1.

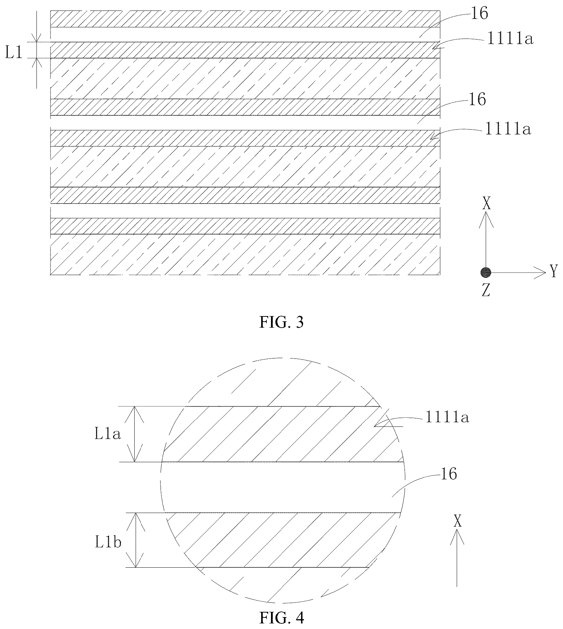

The first finger electrode 16 (i.e., the metal electrode) may be made of metal paste. For example, the metal paste may be one or a combination of aluminium, silver, nickel, copper, and molybdenum. As shown in FIG. 3, the first finger electrodes 16 are distributed along the first direction X and are disposed at the first sub-regions 1111a in a one-to-one correspondence. That is, along the thickness direction Z of the substrate 11, a projection of the first finger electrode 16 is located within the corresponding first sub-region 1111a. At least a partial structure of the first finger electrode 16 penetrates through the first anti-reflection layer 15 and the first passivation layer 14, and is electrically connected (i.e., ohmic connection) to the doped conductive layer 13, so as to collect and transmit the current to the solar cell 1.

In the related art, both the tunneling layer and the doped conductive layer are disposed at the first region and the second region of the first surface of the substrate. That is, the tunneling layer and the doped conductive layer are disposed over the entire surface of the first surface. A thickness of the tunneling layer at the first region is generally the same as that of the tunneling layer at the second region. A thickness of the doped conductive layer at the first region is generally the same as that of the doped conductive layer at the second region. The first finger electrode of the solar cell is only disposed at the first region, so that the doped conductive layer at the first region provides the passivation and an ohmic connection with the first finger electrode. The first finger electrode is not disposed at the second region, so the doped conductive layer at the second region only provides passivation. In order to ensure that a good ohmic contact is formed between the doped conductive layer and the first finger electrode and ensure the passivation effect of the doped conductive layer, a thickness of the doped conductive layer at the first region is usually greater than 100nm. However, for the doped conductive layer at the second region, a thickness of approximately 30 nm is typically sufficient to meet passivation requirements. As the thickness of the doped conductive layer at the second region increases, the photoparasitic absorption of the doped conductive layer at the second region may be increased, resulting in a decrease of the short circuit current of the solar cell and thus affecting the photoelectric conversion efficiency of the solar cell.

In one or more embodiments of the present disclosure, the tunneling layer 12 and the doped conductive layer 13 are only disposed at the first region 1111, enabling the first finger electrode 16 to form a good ohmic contact with the doped conductive layer 13. The tunneling layer 12 and the doped conductive layer 13 are not disposed at the second region 1112, thereby reducing the optical parasitic absorption, increasing the short-circuit current of the solar cell, and thus improving the photoelectric conversion efficiency of the solar cell 1. Additionally, the first passivation layer 14 and the first anti-reflection layer 15 are disposed at the second region 1112, and the first passivation layer 14 and the first anti-reflection layer 15 can provide a good passivation effect for the second region 1112. Therefore, embodiments of the present disclosure can ensure the passivation performance and the contact performance of the first surface 111 of substrate 11 of the solar cell 1 while reducing the optical parasitic absorption of the doped conductive layer 13, thereby improving the photoelectric conversion efficiency of the solar cell 1.

As shown in FIG. 3, a distance L1 between the first finger electrode 16 and an edge of the first sub-region 1111a corresponding to the first finger electrode 16 in the first direction X satisfies a following relational expression: 50µm≤L1≤800µm. As mentioned above, along the thickness direction Z of the substrate 11, the projection of the doped conductive layer 13 overlaps with the first region 1111, so that a distance between the first finger electrode 16 and the edge of the first sub-region 1111a corresponding thereto in the first direction X can also be understood as a distance between the first finger electrode 16 and the edge of the doped conductive layer 13 at the first sub-region 1111a corresponding thereto in the first direction X. L1 may be, for example, 50µm, 100µm, 150µm, 200µm, 250µm, 300µm, 350µm, 400µm, 450µm, 500µm, 550µm, 600µm, 650µm, 700µm, 750µm or 800µm, or may be other values within the above range.

The first finger electrode 16 is electrically connected (i.e., ohmic connection) to the doped conductive layer 13. After the carriers enter the doped conductive layer 13 through the tunneling layer 12, the carriers may move in the doped conductive layer 13 along the first direction X and thus be collected by the first finger electrode 16. The movement of the carriers in the doped conductive layer 13 along the first direction X is also referred to as the lateral transmission of the carriers. In some embodiments, the distance L1 is designed to be 50µm to 800µm, thereby ensuring the lateral transport rate of carriers while reducing the optical parasitic absorption of the doped conductive layer 13, further improving the photoelectric conversion efficiency of the solar cell 1 while facilitating the preparation of the first finger electrode 16. It is understandable by those or ordinary skill in the art that, the above range shall be understood as a preferred range which do not constitute any limitation. Other values may also be adopted depending on actual requirements.

As shown in FIG. 4, in some embodiments, along the first direction X, the first finger electrode 16 includes a first end and a second end. The first sub-region 1111a corresponding to the first finger electrode 16 includes a first edge and a second edge. A distance from the first end to the first edge is L1a, which satisfies a following relational expression: 50µm≤L1a≤800µm. A distance from the second end to the second edge is L1b, which satisfies a following relational expression: 50µm≤L1b≤800µm. L1a and L1b may be the same or different.

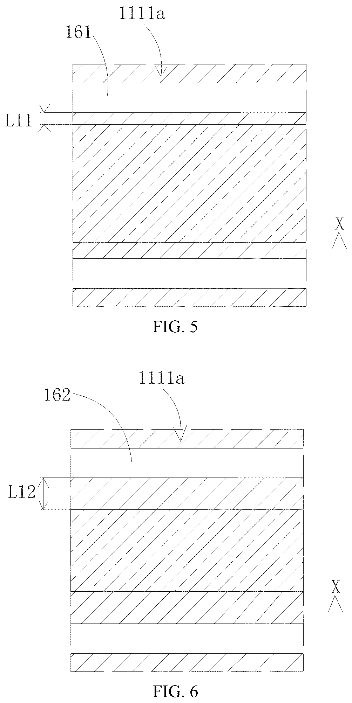

As shown in FIG. 5 and FIG. 6, in one or more embodiments, along the first direction X, the first finger electrode 16 located at a central position of the substrate 11 is designated as a central finger electrode 161. The first finger electrode 16 located at an edge position of the substrate 11 is designated as an edge finger electrode 162. A distance between the central finger electrode 161 and the edge of the first sub-region 1111a corresponding thereto in the first direction X is L11, and a distance between the edge finger electrode 162 and the edge of the first sub-region 1111a corresponding thereto in the first direction X is L12, where L11 is greater than L12, or L11 is smaller than L12.

As mentioned above, along the thickness direction Z of the substrate 11, the projection of the doped conductive layer 13 overlaps with the first region 1111, so that a distance between the central finger electrode 161 and the edge of the first sub-region 1111a corresponding thereto in the first direction X may be a distance between the central finger electrode 161 and the edge of the doped conductive layer 13 at the first sub-region 1111a corresponding thereto in the first direction X. Similarly, a distance between the edge finger electrode 162 and the edge of the first sub-region 1111a corresponding thereto in the first direction X is a distance between the edge finger electrode 162 and the edge of the doped conductive layer 13 on the first sub-region 1111a corresponding thereto in the first direction X.

During the manufacturing process of the solar cell 1, the doped conductive layer 13 may be deposited on a side of the tunneling layer 12 away from the substrate 11 by physical vapor deposition, chemical vapor deposition, plasma enhanced chemical vapor deposition, or the like. Due to the limitation of the production process, the thickness of the doped conductive layer 13 may be non-uniform. For example, the thickness of the doped conductive layer 13 corresponding to the center position of the substrate 11 is relatively large, while the thickness of the doped conductive layer 13 corresponding to the edge position of the substrate 11 is relatively small. In this case, a distance L11 between the central finger electrode 161 and the edge of the first sub-region 1111a corresponding to the central finger electrode 161 in the first direction X may be reduced, and a distance L12 between the edge finger electrode 162 and the edge of the first sub-region 1111a corresponding to the edge finger electrode 162 in the first direction X may be increased, enabling the distance L11 to be smaller than the distance L12. Since the thickness of the doped conductive layer 13 corresponding to the central position of the substrate 11 is relatively large, by reducing the distance L11, the size of the doped conductive layer 13 at the first sub-region 1111a corresponding to the central finger electrode 161 in the first direction X is reduced. That is, the size of the doped conductive layer 13 corresponding to the central position of the substrate 11 in the first direction X is reduced, so as to reduce the photo-parasitic absorption of the doped conductive layer 13. Since the thickness of the doped conductive layer 13 corresponding to the edge position of the substrate 11 is relatively small, by increasing the distance L12, the size of the doped conductive layer 13 at the first sub-region 1111a corresponding to the edge finger electrode 162 in the first direction X is increased. That is, the size of the doped conductive layer 13 corresponding to the edge position of the substrate 11 in the first direction X is increased in the first direction X, thereby improving the passivation performance of the doped conductive layer 13 corresponding to the edge position of the substrate 11 and thus ensuring a good ohmic connection between the edge finger electrode 162 and the doped conductive layer 13.

In some embodiments, the thickness of the doped conductive layer 13 corresponding to the central position of the substrate 11 is relatively small, while the thickness of the doped conductive layer 13 corresponding to the edge position of the substrate 11 is relatively large. As a result, a distance L11 between the central finger electrode 161 and the edge of the first sub-region 1111a corresponding to the central finger electrode 161 in the first direction X may be increased, and a distance L12 between the edge finger electrode 162 and the edge of the first sub-region 1111a corresponding to the edge finger electrode 162 in the first direction X may be reduced, enabling the distance L11 to be greater than the distance L12.

As mentioned above, in view of the non-uniform thickness of the doped conductive layer 13, modifications can be made by adjusting the aforementioned distances L12 and L11 to modify the sizes of the first sub-regions 1111a at different positions on the substrate 11. That is, adjusting the size of the doped conductive layer 13 at the first sub-regions 1111a, so as to ensure the passivation performance and the contact performance of the doped conductive layer 13 while reducing the optical parasitic absorption of the doped conductive layer 13, thereby improving the photoelectric conversion efficiency of the solar cell 1 and ensuring the performance of the solar cell 1.

In some embodiments, the center position of the substrate 11 refers to a regional range rather than a specific point at the center of the substrate 11. A plurality of first finger electrodes 16 may be disposed within this regional range. That is, the number of the center finger electrodes 161 may be one, two, three, or more. Similarly, the edge position of the substrate 11 also refers to a regional range rather than a specific point at the edge of the substrate 11. A plurality of first finger electrodes 16 may be disposed within this regional range. That is, the number of edge finger electrodes 162 may be one, two, three, or more.

As shown in FIG. 5, in one or more embodiments, a distance L11 between the center finger electrode 161 and an edge of the first sub-region 1111a corresponding to the center finger electrode 161 in the first direction X satisfies a following relational expression: 100µm≤L11≤400µm, for example, 100µm, 120µm, 140µm, 150µm, 160µm, 180µm, 200µm, 220µm, 240µm, 250µm, 260µm, 280µm, 300µm, 320µm, 350µm, 360µm, 380µm or 400µm, or other values within the above range.

As shown in FIG. 6, a distance L12 between the edge finger electrode 162 and an edge of the first sub-region 1111a corresponding to the edge finger electrode 162 in the first direction X satisfies a following relational expression: 50µm≤L12≤800µm, for example, 50µm, 100µm, 150µm, 200µm, 250µm, 300µm, 350µm, 400µm, 450µm, 500µm, 550µm, 600µm, 650µm, 700µm, 750µm or 800µm, or other values within the above range.

As mentioned above, due to the limitation of the production process, the thickness of the doped conductive layer 13 may be non-uniform. Therefore, modifications can be made by adjusting sizes of the first sub-regions 1111a at different positions of the substrate 11. That is, adjusting sizes of the doped conductive layer 13 at different positions of the substrate 11, enabling the distance L12 to be greater than the distance L11, or enabling the distance L12 to be smaller than the distance L11, thereby ensuring the passivation performance and the contact performance of the doped conductive layer 13 while reducing the optical parasitic absorption of the doped conductive layer 13, thus improving the photoelectric conversion efficiency of the solar cell 1 and ensuring the performance of the solar cell 1. Additionally, by reasonably limiting the value ranges of the distance L11 and the distance L12, sizes of the doped conductive layers 13 at each position is kept within a reasonable range to ensure the lateral transport rate of carriers, thereby further improving the photoelectric conversion efficiency of the solar cell 1.

In some embodiments, the solar cell may be a solar cell without 0-Busbar (0BB). That is, no busbar is disposed on the first surface and the second surface of the substrate, and the solar cell may use a solder strip to replace the original busbar. The busbar does not need to be provided, so that the consumption of the metal paste is reduced, thereby lowering the production cost of the solar cell.

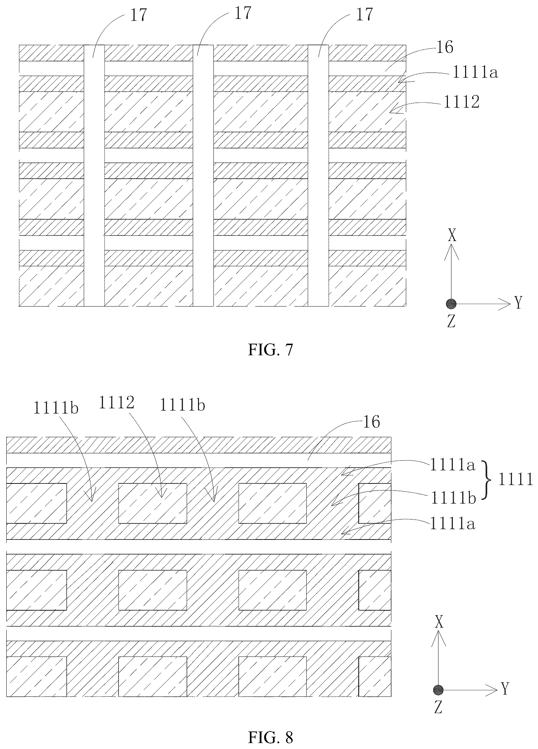

As shown in FIG. 7, in some embodiments, the solar cell 1 further includes a first busbar 17 arranged along a second direction Y orthogonal to the first direction X. Along the thickness direction Z of the substrate 11, the first busbar 17 is located on a side of the first finger electrode 16 away from the substrate 11 and electrically connected to the first finger electrode 16. The first busbar 17 may further collect the current collected by the first finger electrode 16 for output of the current. Along the thickness direction Z of the substrate 11, a projection of a partial structure of the first busbar 17 is located in the first sub-region 1111a, and a projection of another partial structure of the first busbar 17 is located in the second region 1112.

As shown in FIG. 8, in some embodiments, the first region 1111 further includes a second sub-region 1111b. The second sub-region 1111b is connected between any two adjacent first sub-regions 1111a. The second sub-regions 1111b and the second region 1112 are alternately arranged along the second direction Y. The second sub-region 1111b may connect two adjacent first sub-regions 1111a, so that carriers between the doped conductive layers on the two adjacent first sub-regions 1111a may be transmitted along the first direction X through the doped conductive layer disposed on the second sub-region 1111b. Therefore, the arrangement of the second sub-region 1111b is beneficial to the lateral transmission of the carriers along the first direction X, thereby facilitating the collection of the carriers by the first finger electrode 16, and thus improving the efficiency of the solar cell 1.

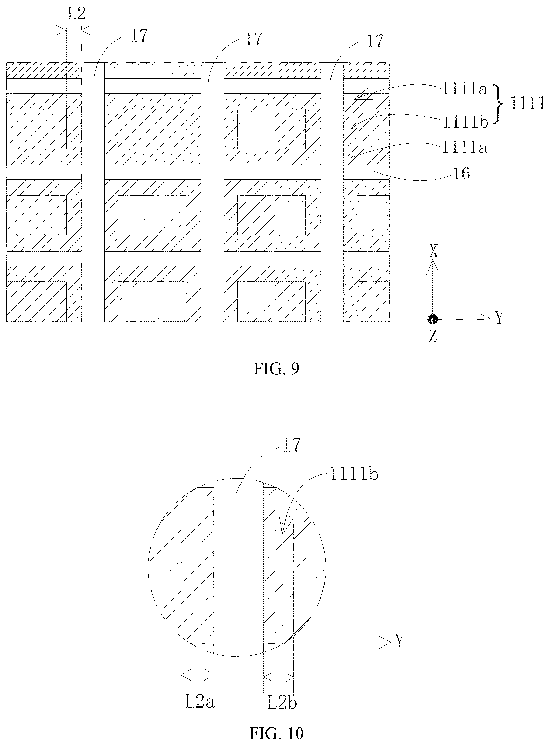

As shown in FIG. 9, in one or more embodiments, the solar cell 1 further includes a first busbar 17. The first busbar 17 is arranged along a second direction Y orthogonal to the first direction X. Along the thickness direction Z of the substrate 11, the first busbar 17 is located on a side of the first finger electrode 16 away from the substrate 11 and is electrically connected to the first finger electrode 16. The first busbar 17 may further collect the current collected by the first finger electrode 16 for output of the current. Along the thickness direction Z of the substrate 11, a projection of a partial structure of the first busbar 17 is located in the first sub-region 1111a, and a projection of another partial structure of the first busbar 17 is located in the second sub-region 1111b. That is, the projections of the first busbars 17 all fall into the first region 1111.

The first region 1111 further includes a second sub-region 1111b, which is connected between any two adjacent first sub-regions 1111a. That is, the second sub-region 1111b can connect two adjacent first sub-regions 1111a. The second sub-region 1111b and the second region 1112 are alternately arranged along the second direction Y, and is disposed corresponding to the first busbar 17. As mentioned above, the arrangement of the second sub-region 1111b is beneficial to the lateral transmission of the carriers along the first direction X, thereby facilitating the collection of the carriers by the first finger electrode 16, and thus improving the efficiency of the solar cell 1.

As shown in FIG. 9, in one or more embodiments, a distance L2 between the first busbar 17 and an edge of the second sub-region 1111b corresponding to the first busbar 17 in the second direction Y satisfies a following relational expression: 0µm≤L2≤400µm. As mentioned above, along the thickness direction Z of the substrate 11, the projection of the doped conductive layer 13 overlaps with the first region 1111, so that a distance between the first busbar 17 and the edge of the second sub-region 1111b corresponding thereto in the second direction Y is a distance between the first busbar 17 and the edge of the doped conductive layer 13 on the second sub-region 1111b corresponding thereto.

In some embodiments, L2 may be 0µm, 10µm, 50µm, 100µm, 120µm, 140µm, 160µm, 180µm, 200µm, 220µm, 240µm, 260µm, 280µm, 320µm, 340µm, 360µm, 380µm, or 400µm, or may be other values within the above range. As mentioned above, the carriers can be laterally transported through the doped conductive layer 13 on the second sub-region 1111b. Therefore, by limiting the distance L2 of the edge of the first busbar 17 and the second sub-region 1111b corresponding thereto in the second direction Y, channels can be provided for the lateral transport of the carriers while reducing the photo-parasitic absorption of the doped conductive layer 13, thereby improving the photoelectric conversion efficiency of the solar cell 1.

In some embodiments, the distance L2 between the edge of the first busbar 17 and the second sub-region 1111b corresponding thereto in the second direction Y is greater than 0µm, so that a size of the second sub-region 1111b in the second direction Y is greater than a size of the first busbar 17, thereby facilitating the printing of the metal paste, and further facilitating the preparation of the first busbar 17.

As shown in FIG. 10, in some embodiments, along the second direction Y, the first busbar 17 includes a third end and a fourth end. The second sub-region 1111b corresponding to the first finger electrode 16 includes a third edge and a fourth edge. A distance from the third end to the third edge is L2a, which satisfies a following relational expression: 0µm≤L2a≤400µm. A distance from the fourth end to the fourth edge is L2b, which satisfies a following relational expression: 0µm≤L2b≤400µm. L2a and L2b may be the same or different.

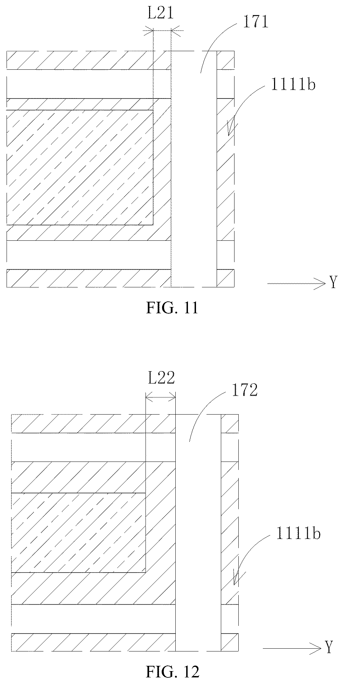

As shown in FIG. 11 and FIG. 12, in one or more embodiments, along the second direction Y, the first busbar 17 located at a central position of the substrate 11 is designated as a central busbar 171. The first busbar 17 located at an edge position of the substrate 11 is designated as an edge busbar 172. A distance between the central busbar 171 and an edge of the second sub-region 1111b corresponding thereto in the second direction Y is L21. A distance between the edge busbar 172 and an edge of the second sub-region 1111b corresponding thereto in the second direction Y is L22. L21 is greater than L22, or L21 is smaller than L22.

A distance between the central busbar 171 and the edge of the second sub-region 1111b corresponding thereto in the second direction Y is a distance between the central busbar 171 and the edge of the doped conductive layer 13 on the second sub-region 1111b corresponding thereto in the second direction Y. Similarly, a distance between the edge busbar 172 and the edge of the second sub-region 1111b corresponding thereto in the second direction Y is a distance between the edge busbar 172 and the edge of the doped conductive layer 13 on the second sub-region 1111b corresponding thereto in the second direction Y.

As mentioned above, due to the limitation of the production process, the thickness of the doped conductive layer 13 may be non-uniform. Therefore, modifications can be made by adjusting the aforementioned distances L22 and L21 to modify the sizes of the second sub-regions 1111b at different positions on the substrate 11. That is, adjusting the size of the doped conductive layer 13 at the second sub-region 111lb, so as to ensure the passivation performance and the contact performance of the doped conductive layer 13 while reducing the optical parasitic absorption of the doped conductive layer 13, thereby improving the photoelectric conversion efficiency of the solar cell 1 and ensuring the performance of the solar cell 1.

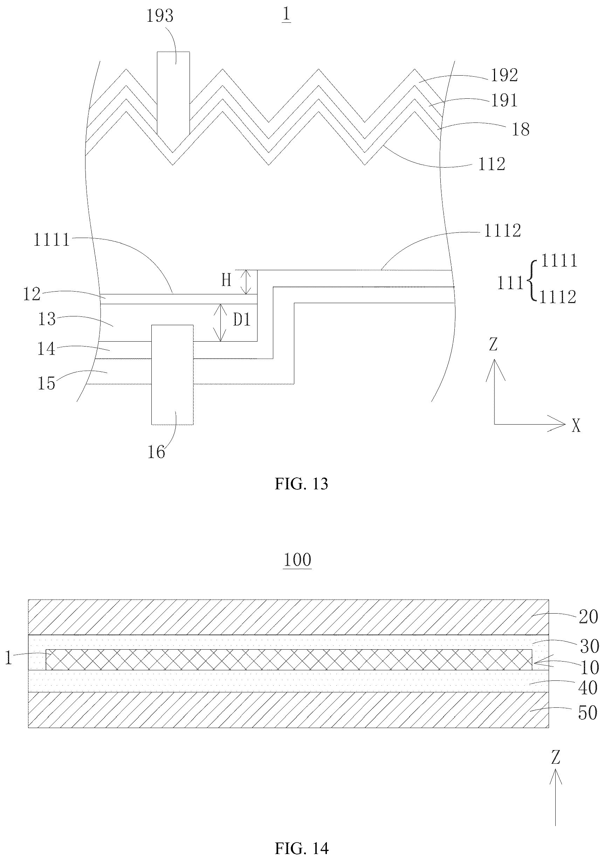

As shown in FIG. 13, in one or more embodiments, along the thickness direction Z of the substrate 11, the thickness D1 of the doped conductive layer 13 satisfies a following relational expression: 60nm≤D1≤300nm. For example, D1 may be 60nm, 70nm, 80nm, 90nm, 100nm, 120nm, 140nm, 160nm, 180nm, 200nm, 220nm, 240nm, 260nm, 280nm, or 300nm, or may be other values within the above range. In some embodiments, the thickness D1 of the doped conductive layer 13 is designed to be 60nm to 300nm, which is beneficial to reducing the contact resistivity of the first finger electrode 16 and ensuring the passivation performance of the doped conductive layer 13 while reducing the optical parasitic absorption of the doped conductive layer 13, and thus ensuring the photoelectric conversion efficiency of the solar cell 1. It is understandable by those or ordinary skill in the art that, the above range shall be understood as a preferred range which do not constitute any limitation. Other values may also be adopted depending on actual requirements.

As shown in FIG. 13, in one or more embodiments, along the thickness direction Z of the substrate 11, a distance from the first region 1111 to the second region 1112 is H, and H satisfies a following relational expression: 0.5µm≤H≤10µm.

Along the thickness direction Z of the substrate 11, there is a height difference H between the first region 1111 and the second region 1112, and the height difference H may be 0.5µm, 1µm, 1.5µm, 2µm, 2.5µm, 3µm, 3.5µm, 4µm, 4.5µm, 5µm, 5.5µm, 6µm, 6.5µm, 7µm, 7.5µm, 8µm, 8.5µm, 9µm, 9.5µm or 10µm, or may be other values within the above range. There is a height difference between the first region 1111 and the second region 1112, causing the first surface 111 of the substrate 11 to exhibit an uneven morphology, allowing the sunlight to be reflected on the surface of the substrate 11 for multiple times, thereby improving the sunlight absorption efficiency of the solar cell 1 and further improving the light conversion efficiency of the solar cell 1. In some embodiments, the height difference between the first region 1111 and the second region 1112 is designed to be 0.5µm to 10µm, which is beneficial to improving the sunlight absorption efficiency of the solar cell 1 while ensuring the passivation effect on the surface of the substrate 11, and thus achieving the optimal performance of the solar cell 1. It is understandable by those or ordinary skill in the art that, the above range shall be understood as a preferred range which do not constitute any limitation. Other values may also be adopted depending on actual requirements.

As shown in FIG. 13, in some embodiments, along the thickness direction Z of the substrate 11, the first region 1111 is located on a side of the second region 1112 away from the second surface 112 of the substrate 11. That is, the first region 1111 protrudes outward from the side of the substrate 11 relative to the second region 1112, thereby forming the height difference H between the first region 1111 and the second region 1112. Such design facilitates the identification and alignment of the first region 1111 during the preparation of the first finger electrode 16, thereby facilitating the preparation of the first finger electrode 16.

As shown in FIG. 13, in one or more embodiments, the solar cell 1 includes an emitter 18, a second passivation layer 191, and a second anti-reflection layer 192. The substrate 11 has a second surface 112 opposite to the first surface 111 along the thickness direction Z of the substrate 11. The emitter 18 is formed inside or above the second surface 112. Along the thickness direction Z of the substrate 11, the second passivation layer 191 is located on a side of the emitter 18 away from the substrate 11, and the second anti-reflection layer 192 is located on a side of the second passivation layer 191 away from the substrate 11.

The emitter 18 and the substrate 11 may jointly form a PN junction structure. When the substrate 11 is the N-type substrate 11 as described above, the emitter 18 may be a P-type emitter 18. The second passivation layer 191 is disposed on the side of the emitter 18 away from the substrate 11. The second passivation layer 191 may be an aluminium oxide layer. The second passivation layer 191 can achieve a good passivation effect on the second surface 112 of the substrate 11, thereby being beneficial to improving the photoelectric conversion efficiency of the solar cell 1. The second anti-reflection layer 192 may be one or a combination of silicon oxide, silicon nitride, and silicon oxynitride. The second anti-reflection layer 192 can provide field passivation to reduce the recombination of carriers, and also has an anti-reflection function to reduce the reflection of sunlight. The second anti-reflection layer 192 is disposed on the second surface 112 of the substrate 11 to improve the light transmittance of the front surface of the solar cell 1, thereby enhancing the carrier concentration on the surface of the substrate 11, improving the short-circuit current and open-circuit voltage of the solar cell 1, and thus improving the photoelectric conversion efficiency of the solar cell 1.

As shown in FIG. 13, in some embodiments, the solar cell 1 includes a second finger electrode 193. The second finger electrode 193 is disposed on a side of the emitter 18 away from the substrate 11. At least a partial structure of the second finger electrode 193 penetrates through the second passivation layer 191 and the second anti-reflection layer 192 and is electrically connected to the emitter 18. The second finger electrode 193 may be made of metal paste. For example, the metal paste may be one or a combination of aluminium, silver, nickel, copper, and molybdenum.

One or more embodiments of the present disclosure provide a tandem solar cell, including a crystalline silicon bottom cell and a perovskite top cell. The crystalline silicon bottom cell includes the back-contact solar cell described above, and the perovskite top cell is electrically connected to the crystalline silicon bottom cell.

The perovskite top cell may include a substrate material, a conductive film, an electron transport layer (titanium dioxide), a perovskite absorption layer (hole transport layer), and a metal cathode. The perovskite material has a relatively high light absorption coefficient and a relatively long carrier diffusion distance. After photons absorbed by the perovskite material are converted into electrons, the electrons are easily collected by an electrode with lower loss, thereby generating a relatively high photogenerated voltage and photogenerated current, so that the perovskite solar cell exhibits relatively high photoelectric conversion efficiency.

By combining the solar cell with the perovskite cell to form a tandem solar cell, a broader range of the solar spectrum can be absorbed, thereby improving the photoelectric conversion efficiency of the tandem solar cell. Since the solar cell has the technical effects described above, the tandem module having the solar cell also has the above technical effects, which will not be repeated herein.

As shown in FIG. 14, one or more embodiments of the present disclosure provide a photovoltaic module 100, including at least one cover plate, at least one encapsulation layer, and at least one solar cell string 10. The encapsulation layer is located between the cover plate and the solar cell string 10. The cover plate is connected to the solar cell string 10 through the encapsulation layer. The solar cell string 10 includes a plurality of solar cells 1 as described in any one of the above embodiments.

The cover plate may include a first cover plate 20 and a second cover plate 50. The first cover plate 20 may be located above the photovoltaic module 100, while the second cover plate 50 may be located below the photovoltaic module 100. The encapsulation layer includes a first encapsulation layer 30 and a second encapsulation layer 40. The first encapsulation layer 30 may be located between the first cover plate 20 and the solar cell string 10, and the second encapsulation layer 40 may be located between the second cover plate 50 and the solar cell string 10.

The first cover plate 20, the first encapsulation layer 30, the solar cell string 10, the second encapsulation layer 40, and the second cover plate 50 may be arranged along the thickness direction Z of the photovoltaic module 100 and laminated together. The first cover plate 20 may be a glass cover plate, and the first cover plate 20 has a relatively high light transmittance. The first encapsulation layer 30 bonds the first cover plate 20 and the solar cell string 10 together to provide encapsulation and protection for the solar cell string 10. The material of the first encapsulation layer 30 may be one or more of ethylene-vinyl acetate copolymer (EVA), polyolefin elastomer (POE), and polyvinyl butyral (PVB). The second encapsulation layer 40 connects the solar cell layer and the second cover plate 50 together, which also provides encapsulation and protection for the solar cell string 10. The material of the second encapsulation layer 40 may be one or more of EVA, POE, and PVB described above. The material of the second cover plate 50 may be glass, or the second cover plate 50 may be formed by compounding a plurality of polymer film layers.

Since the solar cell 1 has the above technical effects, the photovoltaic module 100 having the solar cell 1 also has the above technical effects, which will not be repeated herein.

The above descriptions are only preferred embodiments of the present disclosure and are not intended to limit the present disclosure, and various modifications and changes may be made by those skilled in the art. The scope of the present disclosure shall be defined by the appended claims.

## Claims

1. A solar cell, comprising:
a substrate having a first surface along a thickness direction of the substrate, wherein the first surface includes a first region and a second region, the first region includes first sub-regions, the first sub-regions and the second region are alternately arranged along a first direction, and the first direction is orthogonal to the thickness direction of the substrate;
a tunneling layer formed over the first region;
a doped conductive layer formed over a side of the tunneling layer away from the substrate;
a first passivation layer formed over a side of the doped conductive layer away from the tunneling layer and over the second region;
a first anti-reflection layer formed over a side of the first passivation layer away from the substrate; and
first finger electrodes distributed along the first direction and disposed at the first sub-regions in one-to-one correspondence, wherein at least one of the first finger electrodes is electrically connected to the doped conductive layer, and a distance L1 between the first finger electrode and an edge of the first sub-region corresponding to the first finger electrode in the first direction is in a range of 50µm≤L1≤800µm.

2. The solar cell according to claim 1, wherein along the first direction, the first finger electrode located at a central region of the substrate is designated as a central finger electrode, and the first finger electrode located at an edge region of the substrate is designated as an edge finger electrode;
a distance between the center finger electrode and an edge of a first sub-region corresponding to the center finger electrode in the first direction is L11;
a distance between the edge finger electrode and an edge of a first sub-region corresponding to the edge finger electrode in the first direction is L12; and
wherein L11 is greater than L12, or L11 is smaller than L12.

3. The solar cell according to claim 2, wherein a distance L11 between the central finger electrode and the edge of the first sub-region corresponding to the central finger electrode in the first direction is in a range of 100µm≤L11≤400µm, and
a distance L12 between the edge finger electrode and the edge of the first sub-region corresponding to the edge finger electrode in the first direction is in a range of 50µm≤L12≤800µm.

4. The solar cell according to claim 2, wherein along the thickness direction of the substrate, a projection of the doped conductive layer overlaps with a projection of the first region,
the distance between central finger electrode and the edge of the first sub-region corresponding to the center finger electrode equals to a distance between the central finger electrode and an edge of the doped conductive layer on the first sub-region corresponding to the center finger electrode, or
the distance between edge finger electrode and the edge of the first sub-region corresponding to the edge finger electrode equals to a distance between the edge finger electrode and an edge of the doped conductive layer on the first sub-region corresponding to the edge finger electrode.

5. The solar cell according to claim 4, wherein the doped conductive layer is uneven, when a thickness of the doped conductive layer at the central region of the substrate is greater than a thickness of the doped conductive layer at the edge region of the substrate, L11 is smaller than L12, or
when the thickness of the doped conductive layer at the central region of the substrate is less than the thickness of the doped conductive layer at the edge region of the substrate, L11 is greater than L12.

6. The solar cell according to claim 1, further comprising first busbars arranged along a second direction orthogonal to the first direction, wherein along the thickness direction of the substrate, the first busbar is located on a side of the first finger electrode away from the substrate and is electrically connected to the first finger electrode;
the first region further comprises second sub-regions, the second sub-region is connected between any two adjacent first sub-regions, the second sub-regions and the second region are alternately arranged along the second direction and the second sub-regions are arranged corresponding to the first busbars; and
along the thickness direction of the substrate, a projection of a partial structure of the first busbar is located in the first sub-region, and a projection of another partial structure of the first busbar is located in the second sub-region.

7. The solar cell according to claim 6, wherein a distance L2 between the first busbar and an edge of a second sub-region corresponding to the first busbar in the second direction is in a range of 0µm≤L2≤400µm.

8. The solar cell according to claim 7, wherein along the second direction, the first busbar located at a central region of the substrate is designated as a central busbar, and the first busbar located at an edge region of the substrate is designated as an edge busbar;
a distance between the central busbar and the edge of a second sub-region corresponding to the central busbar in the second direction is L21;
a distance between the edge busbar and the edge of a second sub-region corresponding to the edge busbar in the second direction is L22; and
wherein L21 is greater than L22, or L21 is smaller than L22.

9. The solar cell according to claim 8, wherein along the thickness direction of the substrate, a projection of the doped conductive layer overlaps with a projection of the first region,
the distance between central busbar and the edge of the second sub-region corresponding to the central busbar equals to a distance between the central busbar and an edge of the doped conductive layer on the second sub-region corresponding to the central busbar, or
the distance between edge busbar and the edge of the second sub-region corresponding to the edge busbar equals to a distance between the edge busbar and an edge of the doped conductive layer on the second sub-region corresponding to the edge busbar.

10. The solar cell according to claim 9, wherein the doped conductive layer is uneven, when a thickness of the doped conductive layer at the central region of the substrate is greater than a thickness of the doped conductive layer at the edge region of the substrate, L21 is smaller than L22, or
when the thickness of the doped conductive layer at the central region of the substrate is less than the thickness of the doped conductive layer at the edge region of the substrate, L21 is greater than L22.

11. The solar cell according to any one of claims 1 to 10, wherein along the thickness direction of the substrate, a thickness D1 of the doped conductive layer is in a range of 60nm≤D1≤300nm.

12. The solar cell according to any one of claims 1 to 10, wherein along the thickness direction of the substrate, a distance from the first region to the second region is H, and H is in a range of 0.5µm≤H≤10µm.

13. The solar cell according to claim 12, further comprising: an emitter, a second passivation layer, and a second anti-reflection layer,
wherein the substrate has a second surface opposite to the first surface along the thickness direction of the substrate; and
the emitter is formed in the second surface or on the second surface, and along the thickness direction of the substrate, the second passivation layer is formed over a side of the emitter away from the substrate, and the second anti-reflection layer is formed over a side of the second passivation layer away from the substrate.

14. A photovoltaic module, comprising:
at least one cover plate;
at least one solar cell string comprising a plurality of solar cells according to any one of claims 1 to 13; and
at least one encapsulation layer located between the at least one cover plate and the at least one solar cell string, wherein the at least one cover plate is connected to the at least one solar cell string through the at least one encapsulation layer.

15. A tandem solar cell, comprising:
a crystalline silicon bottom cell including the solar cell according to any one of claims 1 to 13; and
a perovskite top cell electrically connected to the crystalline silicon bottom cell.
